# EUROPÄISCHE PATENTSCHRIFT

(11) **EP 0 931 175 B1**
(45) Veröffentlichungstag und Bekanntmachung des Hinweises auf die Patenterteilung: **11.10.2000**
(21) Anmeldenummer: 97938732.1
(22) Anmeldetag: 17.09.1997
(51) Int. Cl.: C23C 14/56

(54) **TRANSPORT- UND ÜBERGABEEINRICHTUNG**
CONVEYOR AND DELIVERY DEVICE
DISPOSITIF DE TRANSPORT ET DE TRANSFERT

(30) Priorität: 01.10.1996 CH 238696
(43) Veröffentlichungstag der Anmeldung: 28.07.1999
(73) Patentinhaber: BALZERS AKTIENGESELLSCHAFT, 9496 Balzers (LI)
(72) Erfinder: TINNER, Peter, CH-7475 Sevelen (CH); MARTHY, Josef, CH-8880 Walenstadt (CH); SCHERTLER, Roman, D-6922 Wolfurt (AT); VOSER, Stephan, CH-9470 Buchs (CH)
(74) Vertreter: Troesch Scheidegger Werner AG
(86) Internationale Anmeldenummer: CH9700344
(87) Internationale Veröffentlichungsnummer: WO9814632

(56) Entgegenhaltungen:
- EP-A- 0 591 706
- WO-A-87/04414
- DE-A- 3 936 385
- DE-C- 19 515 882
- PATENT ABSTRACTS OF JAPAN vol. 013, no. 360 (M-858), 11.August 1989 & JP 01 118433 A (SEIKO EPSON CORP), 10.Mai 1989,
- PATENT ABSTRACTS OF JAPAN vol. 016, no. 158 (E-1191), 17.April 1992 & JP 04 010553 A (HITACHI LTD;OTHERS: 01), 14.Januar 1992,

## Beschreibung

Die vorliegende Erfindung betrifft eine Transport- und Uebergabeeinrichtung der im Oberbegriff von Anspruch 1 wiedergegebenen Art.

Aus der EP-0 591 706 ist eine Einrichtung dieser Art bekannt. An einer sternförmigen Transportanordnung wird ein scheibenförmiges Werkstück dadurch gehaltert, dass ein anordnungsseitiger Permanentmagnet ein Ankerteil anzieht und dazwischen das scheibenförmige Werkstück gehaltert wird.

In einem Uebergabebereich zu einer weiteren Transportanordnung wird, mittels eines Elektromagneten gesteuert, der Ankerteil von seinem Sitz entgegen der Kraft des erwähnten Permanentmagneten abgehoben und damit das scheibenförmige Werkstück für eine Uebernahme mittels einer mechanisch betätigbaren Halterung an der weiteren Transportanordnung freigegeben.

Umgekehrt, d.h. zur Uebergabe in umgekehrter Richtung, wird der Ankerteil vom Elektromagneten freigegeben und auf das durch die mechanisch betätigbare Halterung eingespannte Werkstück abgelegt, wo es durch die Kraft des Permanentmagneten an der übernehmenden Transportanordnung erfasst wird. Das dazwischenliegende Werkstück wird dann durch Freigabe der mechanisch betätigbaren Halterung an die übernehmende Transportanordnung freigegeben.

Nachteilig an dieser Einrichtung ist, dass an der einen Anordnung eine mechanisch bewegte und angesteuerte Halterung vorgesehen ist. Nebst dem konstruktiven Aufwand hierfür ergeben sich durch die mechanischen Bewegungen unter vakuumtechnischen Aspekten Probleme: Es wird dadurch die Partikelbildung gefördert, was zu erhöhten Ausschussraten von behandelten Werkstücken führt. Je mehr mechanisch bewegte Teile in Vakuumatmosphäre vorhanden sind, desto grösser ist grundsätzlich auch die Gefahr von Störungen im Prozessablauf, womit die Zuverlässigkeit der Anlage beeinträchtigt wird. Im weiteren wird die Zykluszeit der Gesamtanlage durch die erwähnte mechanisch gesteuerte Halterung erhöht, Nachteile, die alle letztendlich die Erstellungs- und Betriebskosten der Anlage und damit die Kosten für behandelte Werkstücke erhöhen.

Ausgehend von einer Einrichtung obgenannter Art, ist es Aufgabe der vorliegenden Erfindung, die erwähnten Nachteile zu beheben.

Dies wird bei Ausbildung der Einrichtung nach dem Kennzeichen von Anspruch 1 erreicht.

Dadurch, dass beide relativ zueinander beweglichen Anordnungen mindestens einen Magnet umfassen, je als Teile der steuerbaren Magnetanordnung, und dabei an beiden Anordnungen der erwähnte Magnet mit dem Ankerteil eine Halterung für das Werkstück bilden und durch Umsteuerung der steuerbaren Magnetanordnung im Uebergabebereich das Ankerteil an der einen oder anderen der Anordnungen haltewirksam wird, ergibt sich eine Einrichtung ohne jegliche mechanische Gelenke, Steuereingriffe etc. Dadurch wird die Zuverlässigkeit der Einrichtung massgeblich erhöht. Die Uebergabe-Zykluszeit wird weiter massgeblich reduziert, vorzugsweise um mehr als 25%, wie von beispielsweise an der nachfolgend detailliert beschriebenen Einrichtung von üblicherweise 10sec auf weniger als 7,5sec. Dadurch entstehen massgebliche Kostenreduktionen, einerseits, auf Grund der Einfachheit der Einrichtung, bei der Erstellung einer entsprechenden Anlage, weiter bei deren Betriebskosten und somit bei den Fertigungskosten an der Anlage behandelter Werkstücke.

Sollen die Werkstücke, dabei insbesondere scheibenförmige Werkstücke, wie insbesondere Mini-Disks, Compact-Disks, Hard-Disks, MO-Disks oder Halbleiterwafer, bei ihrer Behandlung in der Anlage mit einer erfindungsgemässen Einrichtung oberflächenmaskiert werden, so wird der mindestens eine vorgesehene Ankerteil gleichzeitig als Maskierungsorgan eingesetzt, womit Halterung, Uebergabe und Maskierung optimal kombiniert werden. Es versteht sich von selbst, dass damit in noch weit ausgeprägterem Masse die obgenannten Vorteile erzielt werden.

Bevorzugte Ausführungsformen der erfindungsgemässen Einrichtung, ihrer Implementierung an einer Vakuumkammer bzw. einer Vakuumbehandlungsanlage, weiter des prinzipiellen erfindungsgemässen Transport- und Uebergabeverfahrens nebst bevorzugter Verwendung sind in den Ansprüchen 2 bis 14 spezifiziert.

Die Erfindung wird anschliessend beispielsweise anhand von Figuren erläutert.

Es zeigen:
- Fig. 1: schematisch die prinzipielle Wirkungsweise der erfindungsgemässen Einrichtung;
- Fig. 2: schematisch und im Längsschnitt eine bevorzugte Ausführungsvariante der erfindungsgemässen Einrichtung;
- Fig. 3: anhand einer Darstellung gemäss Fig. 2 eine weitere Ausführungsform der Erfindung;
- Fig. 4: in Explosionsdarstellung eine bevorzugte Ausführungsform von Ankerteilen für die Handhabung eines scheibenförmigen Werkstückes mit Zentrumsloch;
- Fig. 5: schematisch den Aufbau einer Behandlungsanlage mit Implementierung der erfindungsgemässen Einrichtung und den Funktionseinheiten der Anlage;
- Fig. 6: in perspektivischer vereinfachter Darstellung die primär behandlungswirksamen Funktionseinheiten der Anlage gemäss Fig. 5;
- Fig. 7a: eine erfindungsgemässe Kammer an der Anlage gemäss den Fig. 5 oder 6, wobei die erfindungsgemässe Einrichtung in Uebernahme-/Uebergabeposition steht;
- Fig. 7b: die Kammer nach Fig. 7a mit der Einrichtung in Transportposition;
- Fig. 8: vergrössert die erfindungsgemässe Einrichtung in Uebergabe-/Uebernahmeposition gemäss Fig. 7a;
- Fig. 9: schematisch und in Aufsicht einen Teil der Anlage gemäss Fig. 6 in Transportposition (a) und in Behandlungs- bzw. Uebernahme-/Uebergabeposition (b).

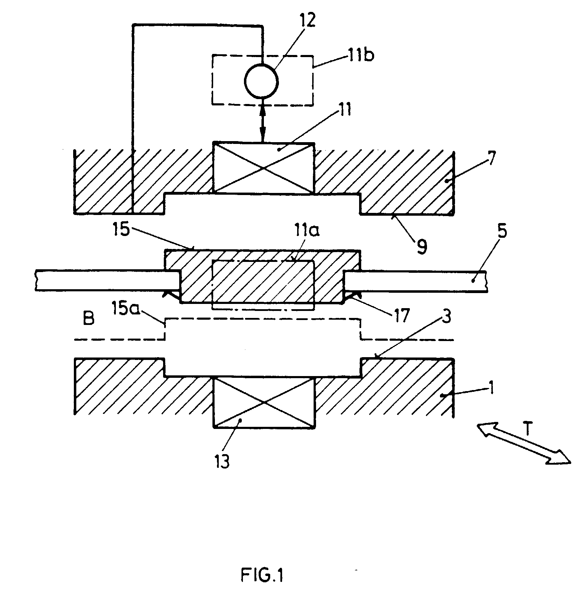

In Fig. 1 ist schematisch eine Transportanordnung 1 dargestellt, welche, wie schematisch mit dem Doppelpfeil T dargestellt, getrieben in einer Vakuumkammer (hier nicht dargestellt) beweglich ist.

Auf ihrem Bewegungspfad wird eine Aufnahme 3 für ein Werkstück 5 in den Uebergabebereich B gegenüber einer weiteren Anordnung 7 mit Aufnahme 9 gebracht. Bei der Anordnung 7 kann es sich um eine stationäre Anordnung oder ebenfalls um eine Transportanordnung handeln.

Beide Anordnungen 1 und 7 weisen mindestens eine Magnetanordnung 11 bzw. 13 auf. Im weiteren ist als separater Teil ein Mitnehmeranker 15 für das hier schematisch als Scheibe mit Zentrumsloch dargestellte Werkstück 5 vorgesehen. Der Mitnehmeranker 15 ist mindestens teilweise aus magnetischem Material. Wenn das Werkstück 5 und der Mitnehmeranker 15, wie gestrichelt bei 15a dargestellt, auf der Transportanordnung 1 aufliegen, so wird durch den Mitnehmeranker 15 auch das Werkstück 5 daran gehaltert. Dies auf Grund der Wechselwirkung der Magnetanordnung 13 und des Mitnehmerankers 15. Liegt (nicht dargestellt) Werkstück 5 und Mitnehmeranker 15 auf der Transportanordnung 7, so wird gleichermassen durch den Mitnehmeranker 15 auch das Werkstück 5 daran gehaltert, auf Grund der Wechselwirkung der Magnetanordnung 11 und des Mitnehmerankers 15.

Im Uebergabebereich B sind die Magnetanordnungen 11 und 13 mindestens Teil einer steuerbaren Magnetanordnung. Unter dem allgemeinsten Aspekt der vorliegenden Erfindung kann die steuerbare Magnetanordnung durch Ausbildung der einen und/oder anderen der Magnetanordnungen 11 bzw. 13 als Elektromagnet realisiert werden; in einer weitaus bevorzugten Ausführungsform handelt es sich aber bei den Magnetanordnungen 11 bzw. 13 um Permanentmagnete. Die ganze erfindungsgemässe Einrichtung basiert dann gemäss Fig. 1 auf dem Einsatz von Permanentmagneten. Die Magnete können aber durchaus am Anker 15 angebracht sein, an den Anordnungen entsprechend Teile aus magnetischem Material.

Zur Uebernahme des Werkstückes 5, weg von der Anordnung 1, an die Anordnung 7 muss die Permanentmagnetanordnung 11 die Rückhaltekraft der Permanentmagnetanordnung 13 überwinden. Dies wird erfindungsgemäss dadurch gelöst, dass die Wirkung der Permanentmagnetanordnung 11 dann stärker ausgebildet wird als diejenige der Magnetanordnung 13. Mit dem Mitnehmeranker 15 in Position 15a wird die Permanentmagnetanordnung 11, wie strichpunktiert in Position lla dargestellt, mittels eines Antriebes 12 gegen die Aufnahme 3 vorgetrieben und übernimmt entgegen der Rückhaltekraft der Magnetanordnung 13 den Mitnehmeranker 15. Bevorzugt sind am Mitnehmeranker 15 lösbare Fixierorgane 17, beispielsweise federnde Laschen, Rasteinrichtungen, wie federnde Rastkugeln, vorgesehen, welche das Werkstück 5 am Mitnehmeranker 15 haltern. Damit wird zusammen mit dem Mitnehmeranker 15 auch das Werkstück 5 durch die Magnetanordnung 11 übernommen und an die Aufnahme 9 zurückgeholt.

Sollen nun von der Anordnung 7 das Werkstück 5 und der Mitnehmeranker 15 wieder an die Anordnung 1 zurückgegeben werden, so wird prinzipiell die Magnetanordnung 11 in die gestrichelt dargestellte Position llb zurückgezogen oder die Magnetanordnung 13 gegen den Mitnehmeranker 15 vorgeschoben (nicht dargestellt), bis bezüglich Rückhaltekraft die Magnetanordnung 13 wieder überwiegt.

Das geschilderte Prinzip beruht somit darauf, einerseits das Werkstück lösbar mit dem Mitnehmeranker zu verbinden und letzteren zwischen einem Permanentmagneten an der einen Anordnung und einem Permanentmagneten an der anderen Anordnung hin- und herzureichen, dabei durch Steuerung der jeweiligen Abstandsverhältnisse das übernehmende Magnet bezüglich seiner Kraft gegenüber dem übergebenden Magneten überwiegend stark wirksam zu gestalten.

Dabei ist ein weiterer, ganz essentieller Vorteil des erfindungsgemässen Vorgehens ersichtlich, nämlich dass keinerlei zusätzliches Transportvehikel für das Werkstück vorgesehen werden muss, weder für die Uebergabe noch für den Transport an einer oder beiden der Anordnungen 7 bzw. 1.

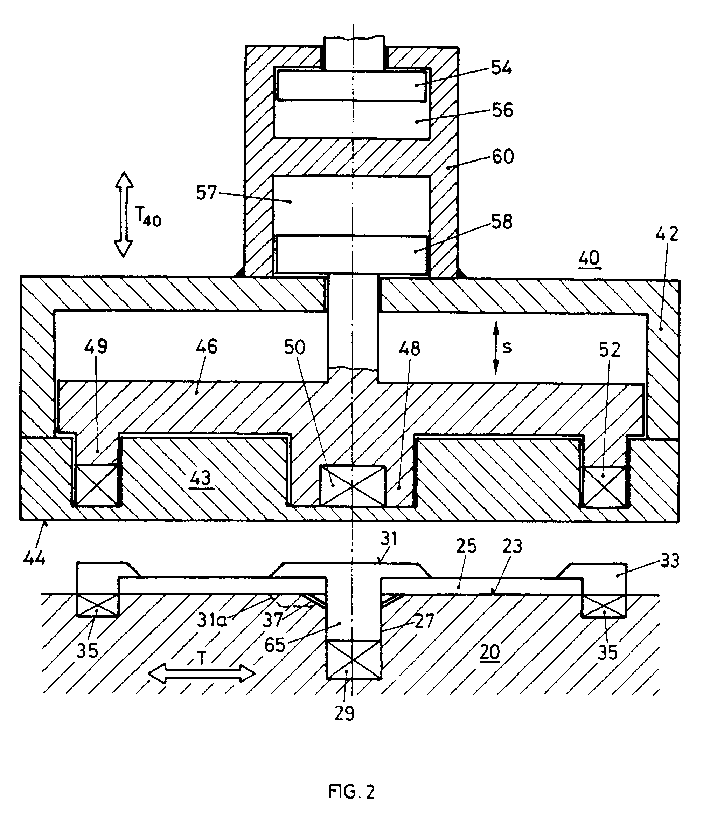

In Fig. 2 ist schematisch eine bevorzugte Ausführungsform der vorliegenden Erfindung dargestellt. Dabei handelt es sich um eine Anordnung, ausgelegt für die Handhabung von kreisförmigen Scheiben mit Zentrumsloch, die, für ihre Behandlung in der Vakuumbehandlungsanlage, sowohl in ihrem Zentrumsbereich wie auch in ihrem Peripheriebereich zu maskieren sind, wie beispielsweise für eine Beschichtungsbehandlung.

An der einen Anordnung 20, wie mit dem Doppelpfeil T dargestellt entsprechend einer Transportanordnung, ist eine Aufnahmefläche 23 für das Werkstück 25 vorgesehen. Zentral in der Aufnahmefläche 23 ist eine Sackbohrung 27 eingearbeitet, an deren Basis ein Permanentmagnet 29 vorgesehen ist. Das Werkstück 25 ist auf die Aufnahmefläche 23 abgelegt und wird dort durch den als Zentralmaske wirkenden Mitnehmeranker 31 aus magnetischem Material festgeklemmt. Die Werkstückscheibe 25 ist peripher durch einen Maskierungsring 33 aus magnetischem Material, und ebenfalls als Anker wirkend, festgespannt auf Grund der Wirkung peripherer Magnete 35 an der Transportanordnung 20.

Der zentrale Mitnehmeranker 31 hält z.B. mit Federlaschen 37 das Werkstück 25 fest. Anstelle solcher Federlaschen können auch Schnappkugeln vorgesehen sein.

Die zweite Anordnung 40 umfasst einen Zylinder 42 mit einer die Aufnahmefläche 44 bildenden Abschlussplatte 43. Im Zylinderraum des Zylinders 42 gleitet ein Kolben 46. An einem zentralen Vorsprung 48 und einem peripheren Ringvorsprung 49 sind Permanentmagnete 50 bzw. 52 angebracht. Durch die Bewegung s des Kolbens 46 und Ausbildung entsprechender Einformungen in der Abschlussplatte 43 des Zylinders 42 werden die Magnete 50 bzw. 52, wie dargestellt, unmittelbar in den Bereich der Fläche 44 gebracht bzw. von dieser zurückgeholt. Die Anordnung 40 ist ebenfalls eine Transportanordnung, woran der Zylinder 42 das Ende einer Transport-Stösselanordnung bildet, T40. Ein Stösselkolben 54 gleitet in einem Stösselzylinderraum 56, der gemeinsam mit einem Antriebszylinderraum 57 für einen Kolben 58 und Kolben 46 in einem Gehäuse 60 vorgesehen ist.

Die Magnete 52 und 50 sind vorzugsweise stärker als die Magnete 35 bzw. 29.

Zur Übernahme des Werkstückes 25 von der dargestellten Position an der Anordnung 20 hinüber an die Anordnung 40 wird mittels der Kolben-/Zylinderanordnung 54/60 mit dem Kolben 46 in dargestellter, vorgeschobener Position der ganze Zylinder 42 gegen das Werkstück 25 und die Anker 33 bzw. 31 vorbewegt, bis die Kraft der Magnete 50, 52 ausreicht, die Anker 33, 31 an die Fläche 44 zu ziehen und damit auch das Werkstück 25. Gehalten durch die Anker 31/33 kann das Werkstück an der Anordnung 40 weitertransportiert werden.

Soll nun, umgekehrt, Werkstück 25 mit Ankern 33/31 an die Anordnung 20 zurükgegeben werden, so werden der Kolben 46 und die Magnete 50, 52 aus der in Fig. 2 dargestellten Position durch Wirkung der Kolben-/Zylinderanordnung 58/60 zurückgeholt, bis schliesslich die Kraft der Magnete 35/29 die verbleibende Rückhaltekraft der zurückgeholten Magnete 50/52 überwiegt. Nach der Übernahme kann der Weitertransport mit der Anordnung 20 erfolgen.

Auf diese Art und Weise wird eine höchst einfache Transportund Uebergabeeinrichtung geschaffen, die ausschliesslich auf der Wirkung von vorzugsweise Permanentmagneten beruht, deren Wechselwirkungen auf magnetische Mitnahme- und Halteanker für das Werkstück durch Steuerung der jeweiligen Wirkungsabstände gesteuert wird.

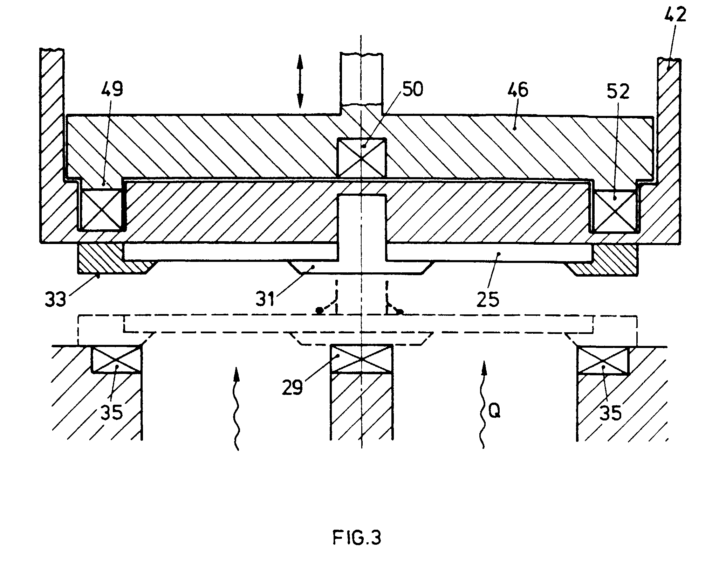

Selbstverständlich ist es durchaus möglich, die eine der beiden in Fig. 2 dargestellten Anordnungen 40 bzw. 20, bevorzugt Anordnung 20, stationär auszubilden, beispielsweise als Zuführungs-Oeffnungsbereich zu einer Behandlungskammer. Dann werden die Halte- und Maskierungsanker 33 bzw. 31 selbstverständlich umgekehrt, wie bei 31a gestrichelt und schematisch dargestellt, angeordnet, und es wird insbesondere der Zentralbereich der Fläche 44 und des Kolbens 46 zur Aufnahme des Mittenfortsatzes 65 der Zentralmaskierung 31 ausgelegt. Diese Konstellation ist schematisch in Fig. 3 dargestellt. Weiterer Erläuterungen hierzu bedarf es nach dem Bisherigen nicht. Die Bearbeitungswirkung ist schematisch mit Q dargestellt.

Bei Vorsehen mehrerer Ankerelemente, wie beispielsweise der zwei gemäss den Fig. 1, 2 oder 3, kann, je nach Auslegung, der eine und/oder andere der Anker mit Haltevorrichtungen gemäss den Feder- oder Kugelrastvorkehrungen, wie sie bei 17 in Fig. 1 dargestellt wurden, versehen sein.

Durch das erfindungsgemässe Vorgehen werden nebst der eleganten Transport- und Uebergabetechnik im eingangs erwähnten Sinne, wie ersichtlich wurde, zusätzliche Maskierungsschritte an der Anlage umgangen, und, wie erwähnt wurde, es wird ein zusätzliches Transportvehikel, welches ein Werkstück, wie die angesprochenen Scheiben, durch die Anlage "begleitet", überflüssig. Damit steigt die Zuverlässigkeit der Anlage, und die Zykluszeiten fallen um mindesten 25%, verglichen mit Anlagen mit separatem Maskierungsschritt.

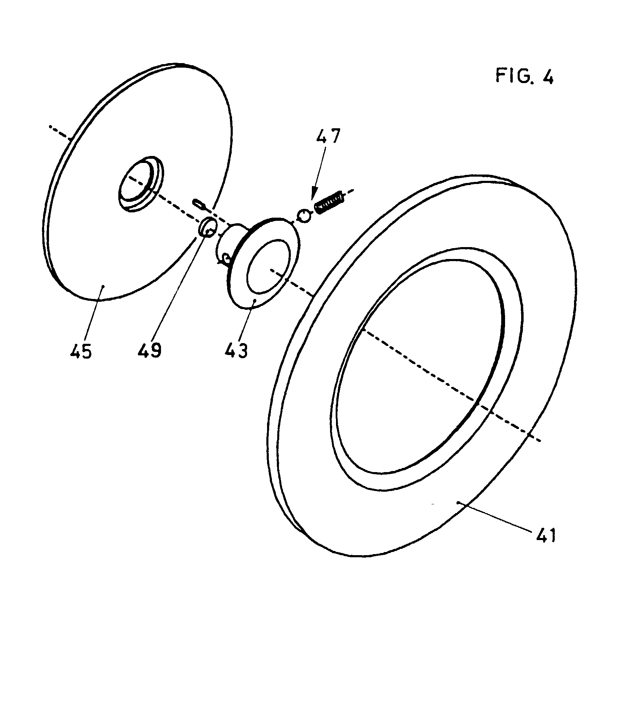

In Fig. 4 ist in Explosionsdarstellung eine bevorzugte Ausführungsform der Mitnehmeranker 41 und 43 bezüglich eines Werkstückes 45 dargestellt. Am zentralen Mitnehmeranker 43 ist mindestens eine Rastkugel 47 als Halteanordnung für das Werkstück 45 vorgesehen. Ein Permanentmagnet 49 ist am Mitnehmeranker 43 als Teil aus magnetischem Material angeordnet.

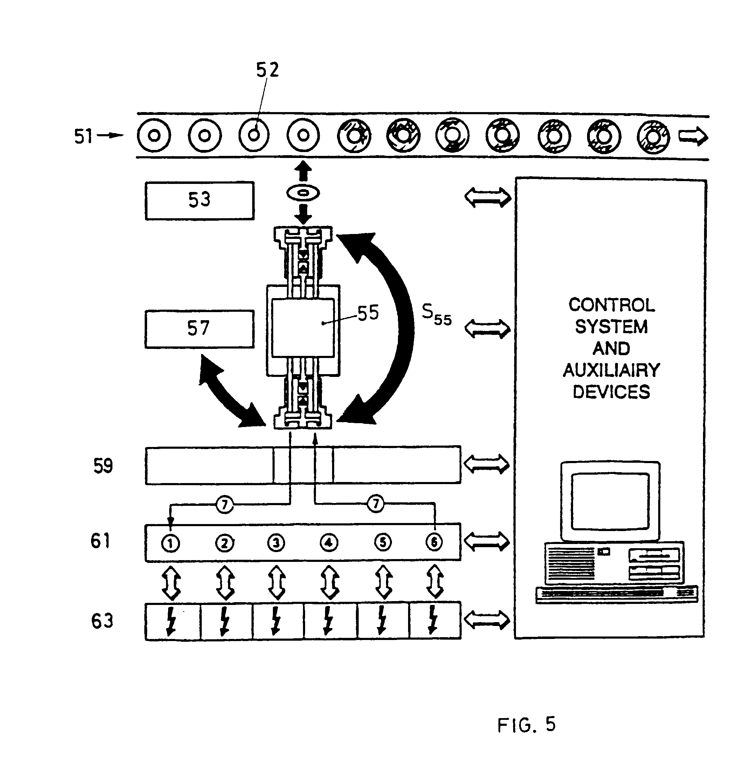

In Fig. 5 ist schematisch eine erfindungsgemässe Anlage mit der erfindungsgemässen Transport- und Uebergabeeinrichtung dargestellt. Es bezeichnen:
- 51:: eine Bandförderanlage für die Werkstückscheiben 52;
- 53:: einen Transportroboter;
- 55:: eine zweiarmige Transportanordnung in einer (nicht dargestellten) Vakuumkammer, um ihre Achse, wie bei S₅₅ dargestellt, schwenkbar, wobei an beiden als Stössel ausgebildeten Armen Teile der erfindungsgemässen Transport- und Uebergabeeinrichtung vorgesehen sind;
- 57:: eine Ladestation für die erfindungsgemäss vorgesehenen Mitnehmeranker, welche auf die Transportarme der Transportanordnung 55, durch eine entsprechende Oeffnung an der nicht dargestellten Vakuumkammer, eingeführt werden;
- 59:: eine Schleusenkammer;
- 61:: eine Haupttransportkammer der Anlage mit mehreren Prozesskammern 63.

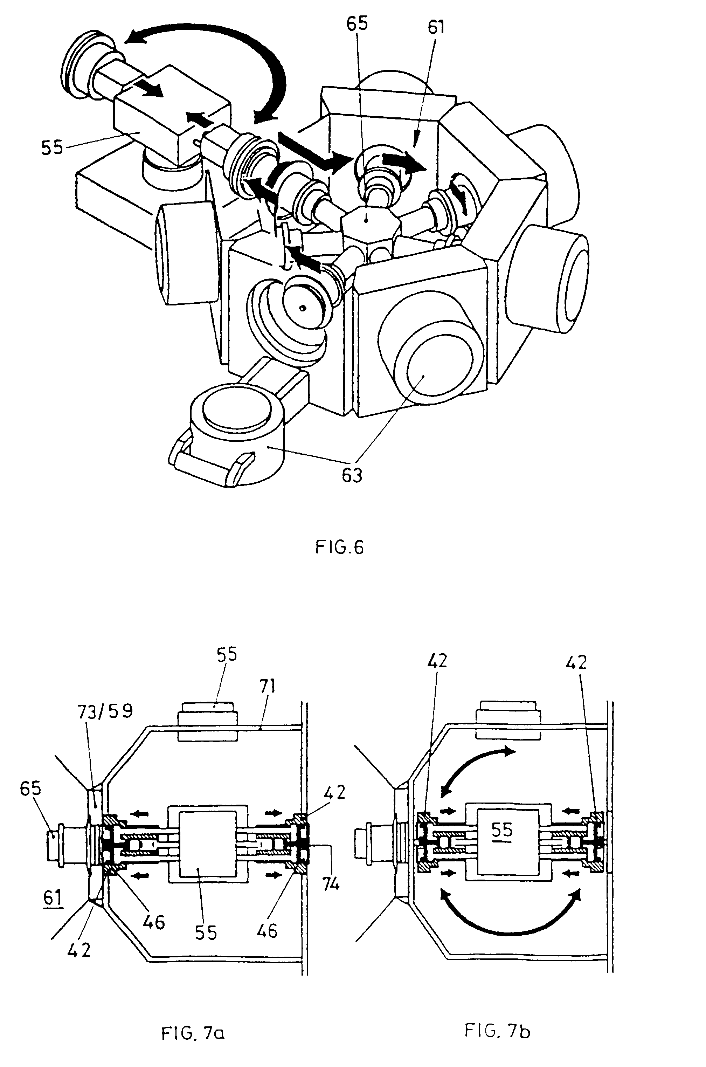

In Fig. 6 sind Prozesskammern 63 dargestellt, eine geöffnet. Sie sind an einer Haupttransportkammer 61 angeflanscht. In der Haupttransportkammer 61 ist ein Drehtransportstern 65 vorgesehen mit einer Mehrzahl Stössel, je an ihren Enden mit den erfindungsgemässen Organen für die Transport- und Uebergabeeinrichtung ausgerüstet. Durch eine Oeffnung werden die Werkstückscheiben von der zweiarmigen Transportanordnung 55 mit den als Masken wirkenden Ankern 41 bzw. 43 gemäss Fig. 4 hin und her transportiert, wie mit den Pfeilen dargestellt. In Fig. 7a ist die zweiarmige Transportanordnung 55 in der zugeordneten Transportkammer 71, wirkverbunden mit der Haupttransportkammer 61, dargestellt. An der Uebergabeöffnung 73 ist die Schleusenkammer 59 integriert, gegebenenfalls auch eine an der Oeffnung 74. Gemäss der Position von Fig. 7a und mit Blick auf Fig. 2 sind die Transportstössel 42 ausgefahren und bilden gemeinsam mit den zugeordneten Oeffnungen in der Kammer 71 eine Dichtung. Ebenfalls sind die Kolben 46 ausgefahren und halten mit den ihnen zugeordneten Magneten 50, 52 (in Fig. 7 nicht eingetragen) die Werkstückscheiben mit den Mitnehmerankern (hier nicht dargestellt) fest. In dieser Position ist die Transportanordnung 55 nicht drehbar, sondern in Uebergabe-/Uebernahmeposition. Mit dem einen dargestellten Stössel der Transportanordnung 65 in der Haupttransportkammer 61 wird ein Werkstück mit den zugeordneten Mitnehmerankern von der Transportanordnung 55 übernommen oder ihr zurückgegeben.

Dasselbe gilt bezüglich der Uebernahme bzw. Uebergabe eines Werkstückes an der zweiten Kammeröffnung 74. Wie im Uebergabebereich zur Haupttransportkammer 61 ersichtlich, dichten beide Stössel, welche auf diese Oeffnung wirken, mit dem zugeordneten Oeffnungsrand derart, dass die Oeffnung selbst, mit ihrer Wandungsstärke, als Schleusenkammer wirkt. Die Schleusenventile werden durch die jeweiligen Stössel gebildet.

Gemäss Fig. 7b sind bei weiterhin ausgefahrenen Kolben 46 die Stössel 42 rückgeholt und damit die Anordnung 55 in schwenkbarer Transportposition.

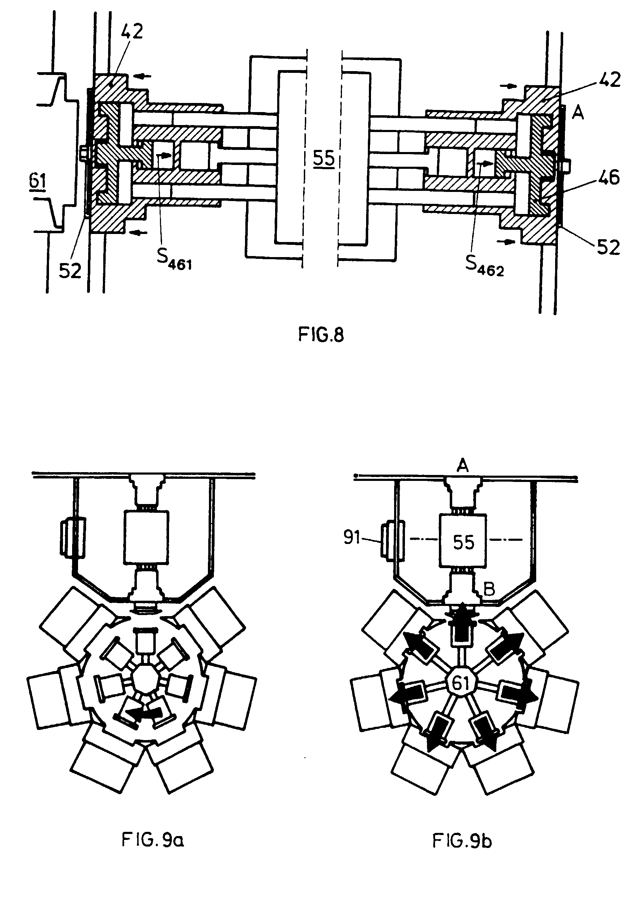

In Fig. 8 sind detaillierter die beiden Stössel an der Transportanordnung 55 gemäss Fig. 7 dargestellt. Beide Stössel sind ausgefahren und dichten an den ihnen zugeordneten Oeffnungsrändern. Wie mit dem Pfeil S₄₆₁ dargestellt, wird der linke Kolben, momentan mit dem einen Stössel der Haupttransportanordnung 61 zusammenwirkend, zurückgeholt, was heisst, dass das Werkstück 52 mit den zugeordneten Mitnehmer- und Maskierungsankern 41, 43 gemäss Fig. 4 an den hauptkammerseitigen Stössel übergeben wird. Gleichzeitig wird der Kolben 46 am rechten Stössel, und wie mit dem Pfeil S₄₆₂ dargestellt, ausgefahren und übernimmt ein Werkstück 52 mit den zugeordneten, als Masken wirkenden Mitnehmerankern 41 bzw. 43.

Insbesondere aus den Betrachtungen von Fig. 7 und 8 ist ersichtlich, dass die Vorschubbewegungen der Kolben 46, an mehreren Stösseln einer Transportanordnung vorgesehen, unabhängig voneinander angesteuert werden können, was gegebenenfalls durchaus auch für die Bewegung der Stössel 42 erwünscht sein kann.

In Fig. 9 ist schematisch die Transportposition (a) der Stössel an der Haupttransportanordnung 65 gemäss Fig. 6 dargestellt sowie in Behandlungsposition bzw. Uebergabeposition gemäss Darstellung (b). Aus Betrachtung von Fig. 9b ist auch unmittelbar der Durchlaufzyklus für Werkstücke ersichtlich:
- in A wird ein unbehandeltes Werkstück von 55 übernommen;
- in B wird ein behandeltes Werkstück von 61 an 55 übergeben;
- 55 wird geschwenkt;
- an A wird das erwähnte behandelte Werkstück ausgegeben, und an B wird das erwähnte unbehandelte Werkstück an 61 weitergegeben, 61 wird weitergedreht.

Wie aus Fig. 8 rechts ersichtlich, können in Position A die Werkstückscheiben wegbefördert werden, ohne Mitentnahme der Maskierungs- und Mitnehmeranker. Diese durchlaufen, rückblickend auf Fig. 9, die Behandlungszyklen der Werkstücke mehrmals und werden an einer Anordnung 91 erst bei Notwendigkeit und nach relativ vielen Behandlungszyklen ersetzt, wozu dann die Transportanordnung 55 in die in Fig. 9b strichpunktierte Zwischenposition geschwenkt wird.

## Patentansprüche

1. Transport- und Uebergabeeinrichtung für ein Werkstück (5, 25) für die Verwendung in einer Vakuumbehandlungsanlage mit
- zwei sich gegenüberliegenden, bewegbaren Anordnungen (1, 7; 20, 40), welche mittels Antrieben relativ zueinander bewegbar sind und die zwischen sich einen Übergabebereich einschliessen,
- einer im Uebergabebereich wirkenden steuerbaren Magnetanordnung (11, 13; 29, 50, 52), welche an einer der Anordnungen an der Seite des Übergabebereiches mindestens einen Teil aus magnetischem Material (11, 13; 29, 35, 50, 52) umfasst,
- mindestens einem mit der steuerbaren Magnetanordnung im Übergabebereich in Wirkverbindung stehendem Ankerteil (15, 31),
wobei der Ankerteil mit dem Teil aus magnetischem Material an der einen Anordnung eine Halterung für ein Werkstück bildet und mittels Steuerung der steuerbaren Magnetanordnung auf diese Anordnung aufgebracht und von ihr abgelöst werden kann,
dadurch gekennzeichnet, dass die steuerbare Magnetanordnung auch an der anderen der relativ zueinander bewegbaren Anordnungen (1, 7; 20, 40), an der Seite des Übergabebereiches, mindestens ein Teil aus magnetischem Material umfasst und der Ankerteil (15, 31, 33) mit dem Teil an der anderen Anordnung auch eine Halterung für das Werkstück bildet, wobei der Ankerteil mittels der steuerbaren Magnetanordnung an die eine oder an die andere der Anordnungen (1, 7; 20, 40) gezogen werden kann.

2. Einrichtung nach Anspruch 1, dadurch gekennzeichnet, dass das Ankerteil (15, 31) eine lösbare Fixierung (17, 37) für das Werkstück umfasst.

3. Einrichtung nach einem der Ansprüche 1 oder 2 für scheibenförmige Werkstücke mit Zentrumsloch, dadurch gekennzeichnet, dass der Ankerteil im wesentlichen pilzförmig ausgebildet ist und vorzugsweise eine lösbare Fixierung für das kreisscheibenförmige Werkstück mit Zentrumsloch umfasst.

4. Einrichtung nach einem der Ansprüche 1 bis 3 für scheibenförmige Werkstücke, dadurch gekennzeichnet, dass der Ankerteil (33) rahmenförmig ausgebildet ist und vorzugsweise eine Fixierung für das Werkstück umfasst.

5. Einrichtung nach einem der Ansprüche 1 bis 4, dadurch gekennzeichnet, dass am Ankerteil eine lösbare Fixierung für ein Werkstück vorhanden ist in Form einer federnden Spanneinrichtung und/oder einer Einrasteinrichtung, vorzugsweise einer Kugelrasteinrichtung.

6. Einrichtung nach einem der Ansprüche 1 bis 5, dadurch gekennzeichnet, dass die steuerbare Magnetanordnung mindestens ein an einer der Anordnungen (7, 40) getrieben verschiebliches Teil aus magnetischem Material (50, 52) umfasst, vorzugsweise dass alle vorgesehenen Magnete der Einrichtung Permanentmagnete sind.

7. Einrichtung nach Anspruch 6, dadurch gekennzeichnet, dass der verschiebliche Teil mit einem in Richtung von einer zur anderen der Anordnungen wirkenden Linearantrieb wirkverbunden ist, welcher vorzugsweise durch eine Kolben-/Zylinderanordnung (46, 48) gebildet ist.

8. Einrichtung nach einem der Ansprüche 6 oder 7, dadurch gekennzeichnet, dass die eine der Anordnungen mindestens einen gegen die andere Anordnung hin verschieblichen Stössel (42) umfasst, wobei Stössel und Teil aus magnetischem Material unabhängig voneinander, vorzugsweise in gleicher Richtung verschieblich sind.

9. Einrichtung nach Anspruch 8, dadurch gekennzeichnet, dass eine Doppelzylinderanordnung (60) vorhanden ist, mit einem ersten auf die Stösselbewegung wirkenden Zylinderraum (56) und einem zweiten auf den Teil wirkenden (57).

10. Einrichtung nach einem der Ansprüche 1 bis 9, dadurch gekennzeichnet, dass der Ankerteil ein Maskierungselement für eine Oberflächenbehandlung des Werkstückes bildet.

11. Anlage mit mindestens einer Einrichtung nach einem der Ansprüche 1 bis 10.

12. Anlage nach Anspruch 11 mit einer Einrichtung nach einem der Ansprüche 8 oder 9, dadurch gekennzeichnet, dass der Stössel und die Oeffnungsumrandung gemeinsam eine lösbare Dichtung bilden, nämlich eine Spaltdichtung oder eine vakuumdichte Dichtung.

13. Verfahren zum Transport und zur Uebergabe eines Werkstückes mittels und zwischen zwei relativ zueinander getrieben bewegbaren Anordnungen in einer Vakuumbehandlungsanlage, dadurch gekennzeichnet, dass ein Mitnehmer für ein Werkstück magnetisch jeweils an der einen oder an der anderen der Anordnungen gehalten wird und mit der jeweiligen Anordnung eine Halterung für das Werkstück bildet, und weiter in einem Uebergabebereich für Mitnehmer und Werkstück die magnetische Haltekraft von der einen Anordnung zur anderen umgesteuert wird.

14. Verwendung der Einrichtung nach einem der Ansprüche 1 bis 10 und/oder der Anlage nach Anspruch 11 und/oder der Anlage nach Anspruch 12 und/oder des Verfahrens nach Anspruch 13 für kreisscheibenförmige Werkstücke, gegebenenfalls mit Zentrumsöffnung, aus nicht magnetischem Material, vorzugsweise für Mini-Disks, Compact-Disks, Hard-Disks, MO-Disks oder Halbleiterwafer.

## Claims

1. Transport and transfer device for a workpiece (5, 25) for use in a vacuum treatment system with
- two opposing mobile devices (1, 7; 20, 40) which can be moved relative to each other by means of drives and which between them enclose a transfer area,
- a magnet arrangement (11, 13; 29, 50, 52) controllable and acting in the transfer area which comprises on one of the devices on the transfer area side at least one part of magnetic material (11, 13; 29, 25, 50, 52),
- at least one armature part (15, 31) actively connected with the controllable magnet arrangement in the transfer area,
where the armature part forms, with the part of magnetic material, a holder for a workpiece on the one device and by control of the controllable magnet arrangement can be brought to this device and removed from it,
characterised in that the controllable magnet arrangement also comprises at least one part of magnetic material on the other of the devices (1, 7; 20, 40) mobile relative to each other on the transfer area side and the armature part (15, 31, 33) together with the part on the other device also forms a holder for the workpiece, where the armature part can be drawn to the one or the other of the devices (1, 7; 20, 40) by means of the controllable magnet arrangement.

2. Device according to claim 1, characterised in that the armature part (15, 31) comprises a releasable fixing (17, 37) for the workpiece.

3. Device according to any of claims 1 or 2 for disc-shaped workpieces with centre hole, characterised in that the armature part is formed essentially mushroom-shaped and preferably comprises a releasable fixing for the disc-shaped workpiece with centre hole.

4. Device according to any of claims 1 to 3, for disc-shaped workpieces, characterised in that the armature part (33) is structured as a frame and preferably, comprises a fixing for the workpiece.

5. Device according to any of claims 1 to 4, characterised in that on the armature part is fitted a releasable fixing for a workpiece in the form of a spring-loaded clamp device and/or an engagement device, preferably a ball detention device.

6. Device according to any of claims 1 to 5, characterised in that the controllable magnet arrangement comprises at least one driven movable part of magnetic material (50, 52) on one of the devices (7, 40), preferably that all magnets provided on the arrangement are permanent magnets.

7. Device according to claim 6, characterised in that the movable part is actively connected with a linear drive acting in the direction from one device to the other, preferably formed by a piston/cylinder arrangement (46, 48).

8. Device according to any of claims 6 or 7, characterised in that the one of the devices comprises at least one ram movable towards the other device (42), where the ram and part of magnetic material can move independently, preferably in the same direction.

9. Device according to claim 8, characterised in that a double cylinder arrangement (60) is present with a first cylinder chamber (56) acting on the ram movement and a second such chamber acting on the part (57).

10. Device according to any of claims 1 to 9, characterised in that the armature part forms a masking element for a surface treatment of the workpiece.

11. System with at least one device according to any of claims 1 to 10.

12. System according to claim 11 with a device according to any of claims 8 or 9, characterised in that the ram and opening edge jointly form a releasable seal, namely a gap seal or a vacuum-tight seal.

13. Process for transport and transfer of a workpiece by means of and between two driven devices movable relative to each other in a vacuum treatment system, characterised in that a carrier for a workpiece is held magnetically on the one or the other of the devices and with the relevant device forms a holder for the workpiece, and further in a transfer area for the carrier and workpiece the magnetic retention force is reversed from the one device to the other.

14. Use of the device according to any of claims 1 to 10 and/or the system according to claim 11 and/or the system according to the claim 12 and/or the process according to claim 13 for circularly disc-shaped workpieces, where applicable with centre opening, of nonmagnetic material, preferably for mini-discs, compact discs, hard discs, MO discs or semi-conductor wafers.

## Revendications

1. Dispositif de transport et de transfert pour une pièce (5, 25) destiné à être utilisé dans une installation de traitement sous vide, comportant
- deux mécanismes mobiles opposés (1, 7 ; 20, 40) qui sont mobiles l'un par rapport à l'autre grâce à des entraînements et qui définissent entre eux une zone de transfert,
- un dispositif à aimant (11, 13 ; 29, 50, 52) apte à être commandé, qui agit dans la zone de transfert et qui comprend sur l'un des mécanismes, sur le côté de la zone de transfert, au moins un élément en matériau magnétique (11, 13 ; 29, 35, 50, 52), et
- au moins un élément formant induit (15, 31) en relation fonctionnelle avec le dispositif à aimant apte à être commandé qui est prévu dans la zone de transfert,
étant précisé que l'élément formant induit forme avec l'élément en matériau magnétique prévu sur l'un des mécanismes une fixation pour une pièce, et peut être posé sur ce mécanisme et détaché de celui-ci à l'aide de la commande du dispositif à aimant apte à être commandé,
caractérisé en ce que le dispositif à aimant apte à être commandé comprend aussi, sur le second des mécanismes (1, 7 ; 20, 40) mobiles l'un par rapport à l'autre, sur le côté de la zone de transfert, au moins un élément en matériau magnétique, et l'élément formant induit (15, 31, 33) forme aussi avec l'élément prévu sur l'autre mécanisme une fixation pour la pièce, ledit induit pouvant être attiré contre l'un ou l'autre des mécanismes (1, 7 ; 20, 40) à l'aide du dispositif à aimant apte à être commandé.

2. Dispositif selon la revendication 1, caractérisé en ce que l'élément formant induit (15, 31) comporte une fixation amovible (17, 37) pour la pièce.

3. Dispositif selon la revendication 1 ou 2 pour des pièces en forme de plaque avec un trou central, caractérisé en ce que l'élément formant induit a globalement la forme d'un champignon et comporte de préférence une fixation amovible pour la pièce en forme de disque avec un trou central.

4. Dispositif selon l'une des revendications 1 à 3 pour des pièces en forme de plaque, caractérisé en ce que l'élément formant induit (33) a la forme d'un cadre et comporte de préférence une fixation pour la pièce.

5. Dispositif selon l'une des revendications 1 à 4, caractérisé en ce qu'il est prévu sur l'élément formant induit une fixation amovible pour une pièce, en forme de dispositif de serrage à ressort et/ou de dispositif d'encliquetage de préférence à bille.

6. Dispositif selon l'une des revendications 1 à 5, caractérisé en ce que le dispositif à aimant apte à être commandé comporte au moins un élément en matériau magnétique (50, 52) mobile de manière entraînée au niveau de l'un des mécanismes (7, 40), et de préférence en ce que tous les aimants prévus du dispositif sont des aimants permanents.

7. Dispositif selon la revendication 6, caractérisé en ce que l'élément mobile est en relation fonctionnelle avec un entraînement linéaire qui agit d'un mécanisme vers l'autre et qui est formé de préférence par un agencement piston/cylindre (46, 48).

8. Dispositif selon la revendication 6 ou 7, caractérisé en ce que l'un des mécanismes comporte au moins un coulisseau (42) mobile vers le second mécanisme, le coulisseau et l'élément en matériau magnétique étant mobiles indépendamment l'un de l'autre, de préférence dans le même sens.

9. Dispositif selon la revendication 8, caractérisé en ce qu'il est prévu un agencement à double cylindre (60) avec un premier espace cylindrique (56) qui agit sur le mouvement du coulisseau, et un second (57) qui agit sur l'élément.

10. Dispositif selon l'une des revendications 1 à 9, caractérisé en ce que l'élément formant induit forme un élément de masquage pour le traitement superficiel d'une pièce.

11. Installation comportant au moins un dispositif selon l'une des revendications 1 à 10.

12. Installation selon la revendication 11, comportant un dispositif selon la revendication 8 ou 9, caractérisée en ce que le coulisseau et le bord de l'ouverture définissent ensemble un joint d'étanchéité amovible, à savoir un joint à fente ou un joint d'étanchéité au vide.

13. Procédé pour le transport et le transfert d'une pièce avec et entre deux mécanismes mobiles l'un par rapport à l'autre, dans une installation de traitement sous vide, caractérisé en ce qu'un organe d'entraînement pour une pièce est retenu par voie magnétique au niveau de l'un ou l'autre des mécanismes et forme avec celui-ci une fixation pour la pièce, et dans une zone de transfert pour l'organe d'entraînement et la pièce, la force de retenue magnétique est inversée d'un mécanisme à l'autre.

14. Utilisation du dispositif selon l'une des revendications 1 à 10 et/ou de l'installation selon la revendication 11 et/ou de l'installation selon la revendication 12 et/ou du procédé selon la revendication 13 pour des pièces en forme de disques, éventuellement avec une ouverture centrale, en matériau non magnétique, de préférence pour des mini-disques, des disques compacts, des disques durs, des disques MO ou des tranches semiconductrices.
